(19) Europäisches Patentamt
European Patent Office
Office européen des brevets

(11) **EP 1 885 059 B1**

(12) **EUROPÄISCHE PATENTSCHRIFT**

(45) Veröffentlichungstag und Bekanntmachung des Hinweises auf die Patenterteilung:
**20.11.2013 Patentblatt 2013/47**

(51) Int Cl.:
*B23K 15/00* *(2006.01)*　　*B23K 15/02* *(2006.01)*
*H01J 37/24* *(2006.01)*　　*H01J 37/31* *(2006.01)*
*H03F 3/217* *(2006.01)*　　*H01J 37/315* *(2006.01)*

(21) Anmeldenummer: 07014317.7

(22) Anmeldetag: **20.07.2007**

(54) **Elektronenstrahlanlage zur Materialbearbeitung und Stromaddieranordnung zur schnellen Ansteuerung einer Induktivität und Bilderzeugungsvorrichtung für eine Elektronenstrahlanlage zur Materialbearbeitung**

Electron beam facility for processing material and current adding device for rapid actuation of inductivity and image creation device for an electron beam facility for processing material

Installation de rayonnement à électrons pour le traitement de matériau et agencement d'ajout de courant pour l'excitation rapide d'une induction et dispositif de production d'images pour une installation de rayonnement à électrons pour le traitement de matériau

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **28.07.2006 DE 102006035793**

(43) Veröffentlichungstag der Anmeldung:
**06.02.2008 Patentblatt 2008/06**

(73) Patentinhaber: **Global Beam Technologies AG**
**82216 Maisach (DE)**

(72) Erfinder:
• **Zosel, Karsten**
**09111 Chemnitz (DE)**
• **Hellmann, Thomas**
**09116 Chemnitz (DE)**

(74) Vertreter: **Kramer - Barske - Schmidtchen**
**Landsberger Strasse 300**
**80687 München (DE)**

(56) Entgegenhaltungen:
**US-A- 3 390 222　　US-A- 3 431 457**
**US-A- 4 891 523**

**Beschreibung**

Die vorliegende Erfindung bezieht sich auf eine Elektronenstrahlanlage zur Materialbearbeitung, wie z.B. Schweißen, Schneiden, Härten o.ä., eine Stromaddieranordnung zur schnellen Ansteuerung einer Induktivität, insbesondere einer Ablenkspule einer Elektronenstrahlkanone, und eine Bilderzeugungsvorrichtung zur Erzeugung eines Bildes eines mit einer Elektronenstrahlanlage bearbeiteten Werkstücks vor und/oder während der Materialbearbeitung.

Im Stand der Technik der Materialbearbeitung mit Elektronenstrahlen ist es bekannt, die Ablenkspulen der Elektronenstrahlkanone mit Analogverstärkern, die eine Großsignalsteuerfrequenz von bis zu 100 kHz aufweisen, anzusteuern. Mit dieser Technik kann eine Genauigkeit des Elektronenstrahls von 1 %o erreicht werden. Die Analogverstärker neigen zu Schwingungen und Überschwingen und Einpendeln im Sprungverhalten.

Im Stand der Technik ist es weiterhin bekannt, Rückstreuelektronen, die von einem mit dem Elektronenstrahl bearbeiteten Werkstück zurückgesteut werden, zeitsynchron (mit Analogtechnik) auf einer Anzeige wie einem Display anzuzeigen oder mit einem entsprechenden Aufzeichnungsgerät aufzuzeichnen.

Aus der DE 1 053 091, der DE 2 149 106 und der US 4,891,523 sind Digital-Analog-Codewandler zum Erzeugen eines Eingangssignals für einen Verstärker für eine Elektronenstrahlanlage bekannt, siehe auch US 3,431,457 und US 3,390,222.

Es ist eine Aufgabe der vorliegenden Erfindung, eine verbesserte Technik zur Ansteuerung der Ablenkspulen einer Elektronenstrahlkanone und eine verbesserte Bilderzeugung aus Rückstreuelektronen, die mit einer schnellen und genauen Ansteuerung der Ablenkspulen möglich wird, anzugeben.

Diese Aufgabe wird gelöst durch einen Verstärker nach Anspruch 1 und eine Elektronenstrahlanlage nach Anspruch 12.

Weiterbildungen der Erfindung sind in den Unteransprüchen angegeben.

Mit den heute durch die Datenverarbeitungstechnologie zur Verfügung gestellten Speichern ist es kostengünstig möglich, bis zu 30 Mbit/s Daten aus einem Speicher auszulesen. Eine Datenrate von 1 Mbit/s stellt also technologisch für die Datenverarbeitung kein Problem dar.

Mit den erzielbaren 100 kHz an Steuerfrequenz für Ablenkspulen lässt sich eine so hohe Datenrate aber nicht beim Ablenken eines Elektronenstrahls einer Elektronenstrahlkanone umsetzen.

Herkömmliche Analogverstärker, die höhere Ansteuerfrequenzen zulassen, wären zu aufwändig und teuer.

Der Verstärker (die Stromaddieranordnung) nach Anspruch 1 ermöglicht demgegenüber eine Art Digitalverstärker, der durch Aufsummieren konstanter, nicht geregelter Ströme einen sehr schnellen Verstärker, der in dem hier in Rede stehenden Frequenzbereich im MHz-Bereich keine Schwingungsneigung aufweist, ermöglicht.

Mit einer solchen Stromaddieranordnung ist es möglich, ein digital gespeichertes Bearbeitungs- und Abtastmuster zur Ansteuerung des Verstärkers, d.h. der Stromaddieranordnung, zu verwenden.

Die Wahl der Widerstandswerte erfolgt vorzugsweise so, dass die Beträge der einzelnen aufzuaddierenden Ströme (Widerstandswerte) stetig größer werden und das Verhältnis von je 2 der aufzuaddierenden Ströme, die in der Reihenfolge der zunehmenden Beträge benachbart sind, $\leq 2$ (Binärcode), vorzugsweise kleiner als 2 ist. Dadurch ist jeder Ausgangsstrom als Wert durch mindestens eine, manchmal auch durch zwei oder mehr mögliche Summen aus den an sich ungeregelten Strömen erreichbar. Die Auflösung der erzielbaren Ströme entspricht dann dem durch den größten Widerstandswert vorgegebenen Strom.

Der Ausgleich von gegebenen, falls vorhandenen, Widerstandstoleranzen und/oder der Ausgleich von temperaturbedingten Widerstandsschwankungen kann z.B. durch einen Codewandler erreicht werden, der eine lineare Übertragungsfunktion sicherstellt.

Mit einem gespeicherten Bearbeitungs- und Abtastmuster, das mit einer hohen Datenrate ausgelesen wird, wird auch die Erzeugung eines Bildes des zu bearbeitenden Werkstückes möglich, indem der Elektronenstrahl "quasi" gleichzeitig das Werkstück bearbeitet und unter Aufrechterhaltung der Schweißkapillare bzw. -kapillaren der Elektronenstrahl in Intervallen über die interessierenden Oberflächenbereiche des in der Bearbeitung befindlichen Werkstückes geführt wird, wobei aus den registrierten Rückstreuelektronen ein Farbbild erzeugt werden kann.

Eine Elektronenstrahlanlage, die mit einem schnellen Verstärker, der die Stromaddieranordnung der hier angegebenen Art nutzt, ausgerüstet ist, kann einerseits sehr schnell effektiv mit den durch die heutige Datenverarbeitungstechnologie zur Verfügung gestellten Datenraten gesteuert werden und andererseits, durch Ausnutzung dieser schnellen Steuerung, unter Verwendung des Elektronenstrahls, der gleichzeitig zur Bearbeitung eines Werkstückes verwendet wird, ein Bild der Oberfläche des in Bearbeitung befindlichen Werkstückes erzeugen.

Weitere Merkmale und Zweckmäßigkeiten ergeben sich aus der Beschreibung von Ausführungsbeispielen anhand der Figuren. Von den Figuren zeigen.

Fig. 1    eine Stromaddieranordnung nach einer Ausführungsform der Erfindung;

Fig. 2    ein Blockschaltbild einer Stromaddieranordnung mit Steuerschaltung; und

Fig. 3    eine schematische Darstellung einer Elektronenstrahlanlage mit Bilderzeugungsvorrichtung nach einer Ausführungsform der Erfindung.

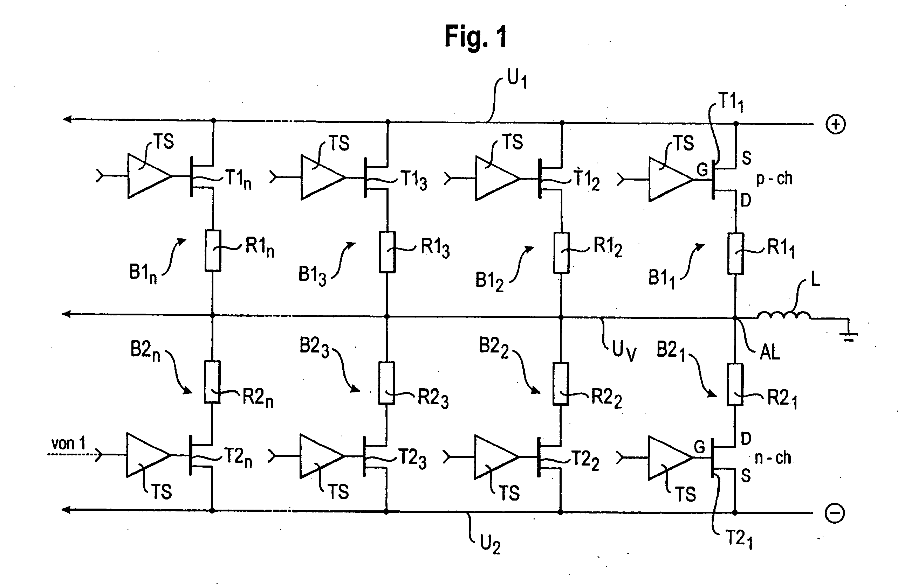

Eine Ausführungsform eines Verstärkers, d.h. eines Digitalverstärkers mit einer Stromaddieranordnung, zur schnellen Ansteuerung einer Induktivität (eines induktiven Elements), wie einer Ablenkspule einer Elektronenstrahlkanone, ist in Fig. 1 gezeigt. Der Verstärker (die Stromaddieranordnung) steuert die Induktivität bevorzugterweise direkt an, d.h. ohne nachgeschaltete Analogverstärker o.ä.

Die Stromaddieranordnung (der Verstärker) weist eine erste Spannungsleiste (Spannungsknoten) $U_1$ auf, die mit einem Ausgang, zum Beispiel dem +-Ausgang (plus-Ausgang), einer spannungsstabilisierten Stromversorgung (nicht gezeigt) zu verbinden ist. Die Stromaddieranordnung weist eine zweite Spannungsleiste (Spannungsknoten) $U_v$, die mit einem Ausgang AL, der (direkt) mit einem Anschluss der Induktivität L zu verbinden ist, auf. Zwischen der ersten Spannungsleiste $U_1$ und der zweiten Spannungsleiste $U_v$ sind jeweils schaltbare Brücken $B1_1$, $B1_2$, ..., $B1_k$, wobei k eine positive ganze Zahl ist, z.B. 7 oder 8, ausgebildet, die bei dieser Ausführungsform aus einem Transistor $T1_1$, $T1_2$, ..., $T1_k$ und einem Widerstand $R1_1$, $R1_2$, ..., $R1_k$, die in Reihe zwischen die beiden Spannungsleisten geschaltet sind, bestehen.

Durchgeschaltete Transistoren sind im Vergleich zu den hier verwendeten strombestimmenden Widerständen sehr niederohmig, so dass der Einfluss der durchgeschalteten Transistoren im Rahmen eines Ausgleiches der Widerstandstoleranzen ausgeglichen wird, wie weiter unten erläutert wird.

Der Widerstandswert des ersten Widerstands $R1_1$ hat den kleinsten Widerstandswert $R_{min}$ der Widerstände $R1_1$, $R1_2$, .... Der zweite Widerstand $R2_2$ hat einen Widerstandswert $WR1_2 = mR_{min}$, wobei $2 \geq m \geq 1$ ist. Der Endwiderstand $R1_n$ hat einen n-ten Widerstandswert $WR1_n = m^{n-1}R_{min}$. Für dieses Ausführungsbeispiel nehmen wir m = 1,9 an. Grundsätzlich ist es ausreichend, dass die Wahl der Widerstandswerte so erfolgt, dass die Beträge der einzelnen aufzuaddierenden Ströme (Widerstandswerte) stetig größer werden und das Verhältnis von je 2 der aufzuaddierenden Ströme, die in der Reihenfolge der zunehmenden Beträge benachbart sind, $\leq$ 2 (Binärcode), vorzugsweise kleiner als 2 ist. Dadurch ist jeder Ausgangsstrom als Wert durch mindestens eine, manchmal auch durch zwei oder mehr mögliche Summen aus den an sich ungeregelten Strömen erreichbar. Die Auflösung der erzielbaren Ströme entspricht dann dem durch den größten Widerstandswert vorgegebenen Strom.

Bevorzugt ist, dass die Widerstandswerte so gewählt werden, dass der Widerstandswert $WR1_j = m_j^{j-1}R_{min}$ (genauer $WR1_j = m_k \times m_{k-1} \times ... \times m_2 \times m_1 \times R_{min}$) mit j = 1, 2, ...., k und $2 \geq mj \geq 1$. Es ist möglich aber nicht nötig, den identischen Wert für alle $m_j$ zu wählen, wie z.B. $m_j$ = 1,9 für alle j im obigen Beispiel.

Bei der in Fig. 1 gezeigten Ausführungsform, bei dem die erste Stromleiste $U_1$ mit dem +-Anschluss der spannungsstabilisierten Stromversorgung (nicht gezeigt) verbunden ist, sind die als Transistoren ausgeführten Schalter $T1_1$, $T1_2$, ... als p-Kanal-FETs ausgeführt. Alternativ können z.B. IGBTs oder andere schnelle Schalter mit niedrigem Einschaltwiderstand verwendet werden.

Bei der in Fig. 1 gezeigten Ausführungsform ist eine dritte Spannungsleiste (Spannungsknoten) $U_2$ vorgesehen, die zur Verbindung mit dem --Ausgang (minus-Ausgang) der spannungsstabilisierten Stromversorgung vorgesehen ist. Zwischen der zweiten Spannungsleiste $U_v$ und der dritten Spannungsleiste $U_2$ sind wie zwischen der ersten und der zweiten Spannungsleiste schaltbare Brücken $B2_1$, $B2_2$, ..., $B2_k$ ausgebildet. Die schaltbaren Brücken bestehen bei diesem Ausführungsbeispiel wiederum aus einem von einem Transistor gebildeten Schalter und einem Widerstand, die in Reihe zwischen die beiden Spannungsleisten geschaltet sind. Der Transistor der schaltbaren Brücken zwischen der zweiten und der dritten Spannungsleiste ist als n-Kanal-FET ausgeführt. Die Widerstandswerte der Widerstände sind analog der Brücken zwischen der ersten und zweiten Spannungsleiste so gewählt, dass $WR2_1 = R_{min}$, $WR2_2 = mR_{min}$ und $WR2_n = m^{n-1}R_{min}$ sind. Natürlich sind auch die oben diskutierten Alternativen und Modifikationen möglich.

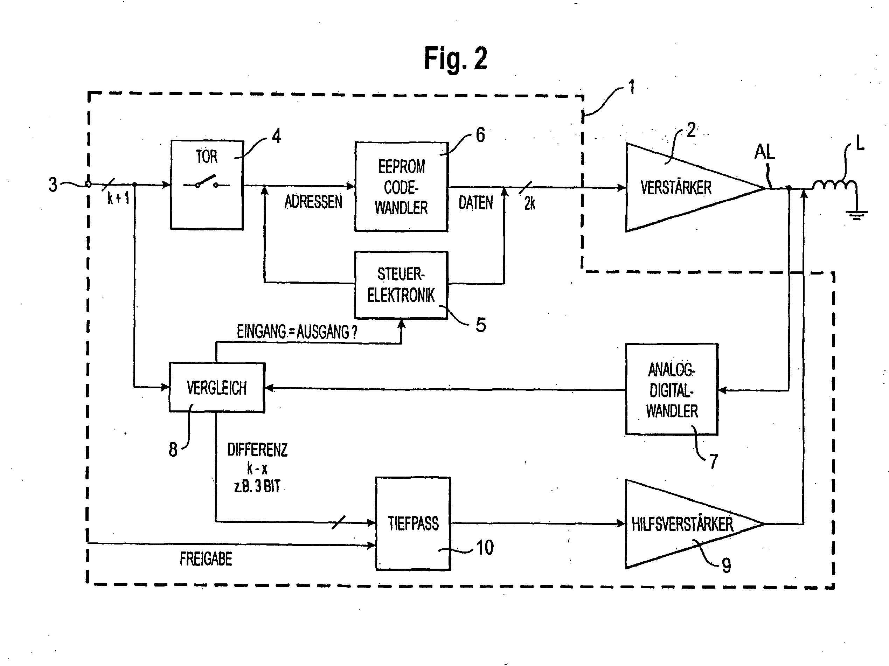

Die Schalter, das heißt in Fig. 1 die Transistoren $T1_1$, ..., $T2_1$, ..., werden von einer in Fig. 2 gezeigten Steuerschaltung angesteuert. Je ein Bit eines Ausgangssignals (Datenworts) der Steuerschaltung 1 wird in Fig. 1 an eine Treiberschaltung TS, die in Fig. 1 als Dreieck dargestellt ist, und die jeweils mit dem Gate der FETs verbunden ist, angelegt. Die Schalter können auch anders implementiert werden, solang eine kurze Schaltzeit < 1 μs bevorzugt < 50 ns, noch bevorzugter $\leq$ 30 ns und ein niedriger Einschaltwiderstand sichergestellt sind.

Diese Steuerschaltung 1 kann also ein Datenwort mit 2k Bit, von dem jeweils 1 Bit den Ein- und Ausschaltzustand eines Transistors darstellt, zum Steuern der Stromaddieranordnung aus Fig. 1 verwenden. Wenn die Stromaddieranordnung aus Fig. 1 nur eine der Spannungsleisten und daher k schaltbare Brücken aufweist, dann genügt ein Datenwort mit kBit zur Ansteuerung der k Schalter. k ist eine positive ganze Zahl aus einem Bereich von 2 bis 20, bevorzugt 4 bis 12.

Die Auswahl der strombestimmenden Widerstände $R1_1$, ... ist relativ einfach. Die strombestimmenden Widerstände sollen aber so gewählt sein, dass sie induktionsarm sind. Es ist natürlich möglich, Widerstände mit sehr geringen Toleranzen auszuwählen. Das ist aber nicht nötig, da die Toleranzen durch die später beschriebene Steuerschaltung leicht ausgeglichen werden können.

Mit dem beschriebenen Verstärker (Stromaddieranordnung) können beliebige Ströme bis zu der Summe der Ströme, die bei Durchschalten aller Brücken einer Polarität erhalten werden, mit einer Auflösung des Strom-

schritts, der durch $R_{min}$ bestimmt wird, erzielt werden.

Im Bereich der niederen Ströme, zum Beispiel der untersten 3 oder 4 Bit, könnten die aufzuaddierenden Ströme auch exakt im Verhältnis 1:2:4 ... (also m = 2) gewählt werden. Die Herstellungstoleranzen und die Temperaturdrift haben in diesem Bereich keinen signifikanten Einfluss auf das Ergebnis. Im Bereich der höheren Ströme, also der höherwertigen Bits des den Stromwert codierenden Datenwortes, sollte das Verhältnis der aufzuaddierenden Ströme allerdings kleiner als 1:2 sein. Das ist der Grund, warum in dem Ausführungsbeispiel der Wert m=1,9 gewählt wurde.

Soll zum Beispiel eine Auflösung der einstellbaren Stromwerte von 12 Bit (= $2^{12}$ = 4096 = 64 x 64 = $2^6$ x $2^6$) erreicht werden, dann muss aufgrund der Wahl des Verhältnisses von 1,9 ein Bit mehr pro Stromrichtung zur Codierung verwendet werden, da $1,9^7$ = 89, 64 nötig wären und $1,9^6$ = 47. Also wäre k = 7 für m = 1,9 anstatt k = 6 für m = 2 bei einer Auflösung von 12 Bit. Würden 6 Bit exakt dual abgebildet, also m = 2, und weitere 6 Bit mit m = 1,8, dann hätte der Verstärker eine Auflösung von 12 Bit, wenn man die Zahl der Bits des Eingangsdatenworts als Maß für die Auflösung betrachtet, oder von 11 Bit (etwas mehr) wenn man die Spanne der einstellbaren Stromwerte als Maß für die Auflösung betrachtet ($2^6$ x $1,8^6$ = 2176 > 2048 = $2^{11}$).

Variable, in Richtung größerer Ströme kleiner werdende Verhältnisse sind in der Praxis günstig (d.h. $m_j < m_{j+1}$ für kleine j), da im Bereich höherer Ströme die Widerstände der durchgeschalteten Transistoren, der Ablenkspule und der Zuleitungen wichtiger werden.

Die Zeitkonstante eines Systems aus der Induktivität L und einer schaltbaren Brücke $B1_1$, ... wird gegeben durch $\tau$ = L/R. Dabei nähert sich der Strom asymptotisch seinem Endwert nach der Gleichung

$$I = I_0(1 - \exp(-t/\tau))$$

Nach Ablauf von sechs Zeitkonstanten würde eine aus 50 mm Entfernung herangeführte Elektronenstrahlposition das gewünschte Ziel nur noch um 125 $\mu$m verfehlen. Wenn man aber den Verstärker (die Stromaddieranordnung) anfänglich um einen entsprechenden Faktor für die Dauer einer Zeitkonstanten $\tau$ übersteuert, dann ist der Endwert schon nach dieser einen Zeitkonstanten erreicht.

Mit einer Induktivität L = 5 $\mu$H und einer Spannung der spannungsstabilisierten Stromversorgung von U = 40 V und einem maximalen Strom von I = 8 A pro Brücke ergibt sich der kleinste Widerstandswert $R_{min}$ mit 5 $\Omega$ und eine Zeitkonstante $\tau$ = 1 $\mu$s.

Diese Vorwärtssteuerung ohne Rückkopplung vermeidet jede Schwingneigung.

Zur Erzielung der angestrebten Genauigkeit, das heißt der Stufen zwischen den durch Addierung erhaltenen Strömen sowie der Linearität der Kennlinie, kann eine Stromaddieranordnung mit einer Steuerschaltung verwendet werden, wie sie in Fig. 2 gezeigt ist.

Eine Stromaddieranordnung (Verstärker) der in Fig. 1 gezeigten Art ist in Fig. 2 als Verstärker 2 gezeigt. Eine Steuerschaltung 1 ist in Fig. 2 mit einer punktierten Linie umgeben.

Die. Steuerschaltung 1 weist einen Dateneingang 3 zum Empfang eines ersten Datenworts mit einer ersten Bitzahl k+1 (= k+Vorzeichen) auf. Der Dateneingang 3 ist mit einem Schalter 4 und einer Vergleichsschaltung 8 verbunden. Der Schalter 4 ist zum Durchschalten des ersten Datenworts zu einem EEPROM 6 ausgebildet. Der Ausgang des EEPROM 6, das einen Codewandler darstellt, ist mit dem Eingang des Verstärkers 2 verbunden. Der Ausgang AL des Verstärkers 2 ist mit der Induktivität L verbunden. Mit dem Ausgang AL ist weiterhin ein Analog-Digital-Wandler 7 verbunden, der ein zweites Datenwort mit der ersten Bitanzahl ausgibt. Die Vergleichsschaltung 8 empfängt das erste Datenwort von dem Dateneingang 3 und das zweite Datenwort von dem Analog-Digital-Wandler 7. Die Vergleichsschaltung 8 ist zum Vergleichen der beiden Datenworte und zum Ausgeben des Vergleichsergebnisses, also der Differenz einschließlich der Differenz 0 (= Identität), ausgebildet.

Die Vergleichsschaltung 8 ist so ausgebildet, dass das Vergleichergebnis einerseits zum Einstellen bzw. Programmieren des EEPROM 6 an eine Abgleichsteuerschaltung 5 als Datenwort mit derselben Bitzahl wie das erste Datenwort (k+1) und andererseits als Datenwort mit einer geringeren Bitzahl k-x, z.B. 3 oder 4, im Normalbetrieb an einen Hilfsverstärker 9 über einen Tiefpaß 10 ausgegeben wird. Der Hilfsverstärker 9 ist vorzugsweise in derselben Weise aufgebaut wie der Verstärker 2, aber mit weniger Brücken ((k-x-1) pro Stromrichtung), also eine Art Miniausführung des Verstärkers 2.

Beim erstmaligen Aufbau der Verstärkeranordnung 1, 2 oder immer, wenn an der angesteuerten Induktivität, also z.B. dem Spulensystem einer Elektronenstrahlkanone, oder den Zuleitungen oder der Verstärkeranordnung etwas geändert, ausgetauscht oder repariert wird, ist ein erster Verstärkerabgleich durchzuführen. Dabei ist der Schalter 4 geöffnet. Die Abgleichsteuerschaltung 5 gibt jede mögliche Bitkombination (z.B. $2^{12}$ = 4096 für k=12) nacheinander als Eingabewert in den Verstärker 2 ein, bis der Ausgangsstrom konstant ist, z.B. für 10 Zeitkonstanten. Für jede mögliche Bitkombination wird der real fließende Ausgangsstrom des Verstärkers 2 gemessen und der Meßwert durch den A/D-Wandler 6 gewandelt. Als erstes Datenwort wird vorzugsweise 0 an die Vergleichsschaltung angelegt, so dass von der Vergleichsschaltung 8 als Differenz das zweite Datenwort an die Abgleichsteuerschaltung 5 ausgegeben wird. Die Abgleichsteuerschaltung 5 sucht dann in der Umgebung des gerade anliegenden 12 Bit Datenwortes (gemeint sind hier die 12 Transistoreingänge einer Polarität) nach der Bitkombination, die zufällig alle Verstärkerfehler ausgleicht und den gewünschten Strom liefert. Zu jeder möglichen 12-Bit-Kombination pro Stromrichtung (also 13 Bit mit Vorzeichen) am Eingang des EEPROM 6 wird also eine 12-Bit-Kombination gesucht, die die Stromaddieranordnung 2 bekommen muss, um das richtige Ergebnis zu liefern. Das alles für jede Stromrichtung einzeln.

Das Ergebnis wird im EEPROM abgelegt. Im späteren Betrieb wird zu jeder der 4096 12-Bit-Adressen das entsprechende 12-Bit-Datenwort entsprechend Stromrichtung ausgegeben, die jeweils anderen 12-Bit haben Potential logisch L, die Verstärkerhälfte bleibt unbenutzt.

In dem EEPROM 6 ist also eine Tabelle abgelegt, die das zu einem gewünschten Stromausgangswert, der durch das erste Datenwort codiert wird, gehörende Datenwort mit einer Bitzahl 2k zur Ansteuerung der schaltbaren Brücken als Ausgangsdatenwort speichert.

Durch Widerstandstoleranzen und Temperaturdrift verändert sich aber der von dem Verstärker 2 ausgegebene Stromwert bei Eingabe eines identischen Datenwortes. Dafür ist die zweite Funktion der Steuerschaltung 1 vorgesehen. Im Normalbetrieb ist der Schalter 4 geschlossen und der EEPROM 6 wird über den Eingang 3 angesteuert. Die zweite Funktion benutzt die Abgleichsteuerschaltung 5 nicht. Sie dient der (vergleichsweise geringfügigen) Nachkorrektur des ausgegebenen Stromwerts während der Normalbetriebsphase (z.B. Kompensation der temperaturbedingten Änderungen eines Widerstandswerts). Dieser kann mit Hilfe des Hilfsverstärkers 9, der nach Freigabe über den Tiefpass 10 mit einem Datenwort von zum Beispiel 3 (oder 4 oder 5) Bit angesteuert wird, die aus der Differenz des ersten und des zweiten Datenwortes durch die Vergleichsschaltung 8 abgeleitet werden, ausgeglichen werden.

Aufgrund der möglichen schnellen Ansteuerung des Verstärkers 2 kann ein Abgleich zur Korrektur dieser Abweichungen auch in sehr kurzen Arbeitspausen während der Bearbeitung eines Werkstücks erfolgen, um temperaturbedingte Widerstandsänderungen auszugleichen. Dazu wird, wie bereits beschrieben wurde, das erste Datenwort mit dem zweiten Datenwort verglichen und die Ausgabe des Codewandlers 6 entsprechend angepasst.

Der Vorteil dieser Vorgehensweise ist die zeitliche Entkopplung der Regelung, die zu jeder Eingangsgröße die korrekte Ausgangsgröße erzeugt, von der erforderlichen sehr schnellen Arbeitsweise des Verstärkers. Ein solcher Aufbau kann keine Regelschwingung erzeugen. Bei Verwendung eines 12 Bit Eingangsdatenwortes pro Verstärkerseite für den Verstärker 2 hat man praktisch 4096 Stellgrößen zur Verfügung, um alle statischen Ungenauigkeiten zu korrigieren. Die dynamischen Eigenschaften des Systems sind weitestgehend mit der (sehr kleinen) Zeitkonstante $\tau$ beschrieben.

Es ist auch möglich, die Rückkopplung nicht über den A/D-Wandler 6, sondern durch Messung des Auftrefforts der Elektronen im Arbeitsraum, zum Beispiel mit einem Drahtgitter mit voneinander isolierten Drähten, zu ermitteln. Mit einer solchen Anordnung sind technologisch bedingte und wegen der begrenzten Spulenquerschnitte physikalisch unumgängliche Fehler wie Kissenfehler ausgleichbar. In diesem Fall können alle 24 Bit für die X- und die Y-Richtung insgesamt zur Adressierung eines Speichers mit 16 M x 3 Byte verwendet werden, und die 24 Bit-Daten werden wiederum zur Ansteuerung der beiden Leisten des Verstärkers 2 verwendet.

Zusammenfassend, die Stromaddieranordnung, die als schneller Verstärker zur schnellen Ansteuerung einer Induktivität, insbesondere einer Ablenkspule einer Elektronenstrahlkanone verwendbar ist, ermöglicht das Addieren einzelner, jeweils für sich ungeregelter Ströme bekannter Größe zu einem Gesamtstrom, was aufgrund der sehr kleinen erreichbaren Zeitkonstanten für das System eine schnelle und zuverlässige "Verstärkung", genauer Ausgabe, eines steuerbaren Stroms mit konstanter Spannung ermöglicht.

Das Verhältnis von je 2 der aufzuaddierenden Ströme ist vorzugsweise ≤ 2, was eine Art Binärcode der aufzuaddierenden Ströme bildet. Vorzugsweise wird das Verhältnis in Richtung der größeren, der zu schaltenden Ströme kleiner.

Eine lineare Übertragungsfunktion des Verstärkers bzw. der Stromaddierschaltung wird z.B. durch einen Codewandler erreicht, der herstellungsbedingte Widerstandstoleranzen ausgleicht und nach Beaufschlagen des Verstärkers mit den später zu erzielenden Strömen in thermischem Gleichgewicht die temperaturbedingten Widerstandsänderungen ausgleicht.

Dynamische Laständerungen an den Hochstromwiderständen im Rahmen der relativ großen Zeitkonstante für thermisch bedingte Widerstandsänderungen können durch die Steuerschaltung so langsam ausgeregelt werden, dass eine Schwingungsneigung durch Rückkopplung in diesem Regelkreis ausgeschlossen ist.

Für kontinuierliche Stromänderungen kann die Spule nahe an ihrem Fußpunkt kurzgeschlossen werden, damit mit einer großen Zeitkonstante der vorher in der Spule fließende Strom aufrecht erhalten wird, während in dem Verstärker ein Schaltvorgang stattfindet.

Mit einem derart schnellen Verstärker wird auch eine Bilderzeugung mit der Elektronenstrahlanlage zur Materialbearbeitung durch eine Abtastung der Oberfläche des in Bearbeitung befindlichen Werkstückes mit dem selben Elektronenstrahl, der zur gleichen Zeit zur Bearbeitung des Werkstückes verwendet wird, und Auswertung der rückgestreuten Elektronen möglich.

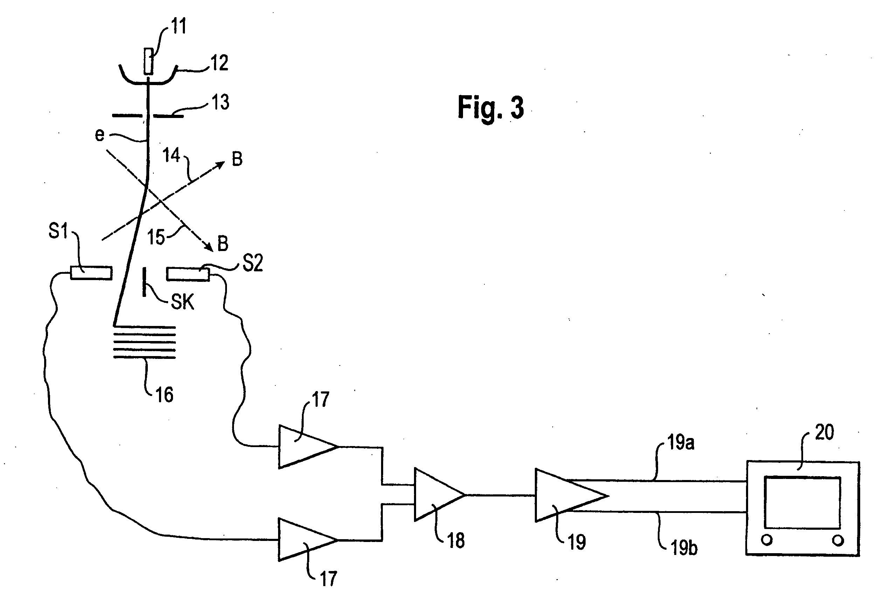

Fig. 3 zeigt schematisch eine solche Elektronenstrahlanlage. Durch Kathode 11, Wehneltzylinder 12 und Anode 13 wird ein Elektronenstrahl e erzeugt, der durch zueinander senkrechte Magnetfelder 14, 15, die durch die Ablenkspulen der Elektronenstrahlkanone erzeugt werden, in seiner Strahlrichtung gesteuert wird.

Während einer Schweißbearbeitung eines Werkstücks wird eine Schweißkapillare SK erzeugt.

Unter Aufrechterhaltung der Schweißkapillare SK kann der Strahl in kurzen Zeitintervallen interessierende Oberflächenbereiche des Werkstückes mit einem Abtastmuster 16 abtasten, so dass durch Erfassung der Rückstreuelektronen ein Bild des abgetasteten Oberflächenbereichs erzeugt werden kann.

Dazu weist die Elektronenstrahlanlage zwei Sensoren S1, S2 auf, die voneinander unabhängig Rückstreuelektronen erfassen können. Die Sensoren S1, S2 erzeugen jeweils ein Ausgangssignal, das der Intensität der Rückstreuelektronen, die durch den entsprechenden Sensor erfasst werden, entspricht. Die Ausgangssignale der Sensoren S1, S2 werden an den Eingang je eines Vorverstärkers 17 angelegt. Die Ausgangssignale der beiden Vorverstärker 17 werden an die beiden Eingänge eines Differenzverstärkers 18 angelegt. Das Ausgangssignal des Differenzverstärkers 18 wird an den Eingang eines Endverstärkers 19 angelegt, der zwei sogenannte Gegentaktausgänge aufweist. An dem einen Gegentaktausgang 19a wird das verstärkte Eingangssignal des Endverstärkers 19 ausgegeben. An dem anderen Gegentaktausgang 19b wird das verstärkte Eingangssignal des Endverstärkers 19 mit umgekehrtem Vorzeichen ausgegeben. In anderen Worten, der Endverstärker 19 gibt das verstärkte Differenzsignal und das negierte verstärkte Differenzsignal aus.

Mit diesen beiden Signalen kann zum Beispiel auf einem Display mit RGB-Eingang ein Farbbild erzeugt werden, bei dem das eine Signal rot und das andere Signal grün dargestellt wird. Die Farbdarstellung führt zu dem visuellen Eindruck einer schräg beleuchteten Kulisse, ähnlich einer colorierten Landkarte mit Hervorhebung von Bergen und Tälern. Es werden damit optische Täuschungen vermieden, die bei einer Grauwertdarstellung beispielsweise nicht erlauben, das Loch eines Körnerschlags von einer kegelförmigen Erhebung zu unterscheiden. Dadurch können Bedienungsfehler vermieden werden.

Alternativ ist es auch möglich, die Signalauswertung digital auszuführen, d.h. eine digitale Darstellung der Sensorsignale zu wählen, die dann entweder in digitaler Form gespeichert oder auf einem Digitalbildschirm dargestellt werden.

Der Übergang von analoger zu digitaler Technik ist prinzipiell an jeder Stelle zwischen Sensoren S1, S2 und den Ausgängen des Endverstärkers 19 möglich.

Eine Elektronenstrahlanlage mit einer Elektronenstrahlkanone mit Ablenkspulen, einer Stromaddieranordnung der zuvor beschriebenen Art zur Ansteuerung der Ablenkspulen, und einer Bilderzeugungsvorrichtung der zuvor beschriebenen Art ermöglicht einerseits eine sehr schnelle und genaue Steuerung der Strahlrichtung mit einer bei Analogverstärkern nur sehr schwer erreichbaren Wiederholgenauigkeit, die mit der bisherigen Technik nicht möglich war, und sie ermöglicht andererseits eine Erzeugung eines Digitalbildes von interessierenden Oberflächenbereichen. Diese beiden Vorteile können unabhängig voneinander erreicht werden.

Die Datenworte, mit denen die Stromaddieranordnung angesteuert wird, stellen letzten Endes eine Art Bitmap und somit eine Karte des abzutastenden Werkstücks dar. Wenn also eine Korrelation zwischen den erfassten Rückstreuelektronen und der Ansteuerung der Stromaddieranordnung hergestellt wird, dann ergibt jedes entsprechende Datenpaar aus Datenwort und Sensorwerten je einen Punkt einer Rückstreuelektronenintensitätskarte.

Diese kann nun noch dadurch genauer gestaltet werden, dass nicht das erste Datenwort, das in die Steuerschaltung 1 eingegeben wird, sondern das zweite Datenwort, das aus dem von dem Verstärker 2 tatsächlich ausgegebenen Spulenstrom gewonnen wird, für die Herstellung der Karte genommen wird. Es lässt sich also pixelweise ein Bildspeicher mit den gewonnenen Sensorwerten füllen.

Eine solche bildliche Darstellung des abgerasteten Oberflächenbereichs kann einerseits zur visuellen Kontrolle und andererseits für Qualitätsmanagementaufgaben und auch zur Strahlnachführung markante Bereiche zur weiteren Analyse ergeben.

Das Verwenden der Stromaddieranordnung für die Ansteuerung der Ablenkspulen führt also in Kombination mit der Bilderzeugungsvorrichtung zu einer besonders bevorzugten Ausbildung der Bilderzeugungsvorrichtung, da die Bitmap, mit der die Stromaddieranordnung angesteuert wird, auch zur Bilderzeugung in der oben beschriebenen Weise verwendet werden kann.

Es wird nach einem Aspekt eine Bilderzeugungsvorrichtung für eine Elektronenstrahlanlage zur Materialbearbeitung offenbart, die zur Erzeugung eines Bildes eines mit einer Elektronenstrahlkanone bearbeiteten Werkstücks während der Bearbeitung angepasst ist, wobei die Elektronenstrahlkanone eine Ablenkvorrichtung zur gesteuerten Ablenkung des Elektronenstahls aufweist, mit einem Speicher zur Speicherung eines digitalen Bearbeitungs- und Abtastmusters, das einen Weg eines Elektronenstrahls (e) in einem Bearbeitungs- und Abtastbereich auf dem Werkstück definiert, einer Steuerschaltung (1, 2), die zur Ansteuerung der Ablenkvorrichtung zur Ablenkung des Elektronenstrahls (e) gemäß des Bearbeitungs- und Abtastmusters angepasst ist, einem Sensorsystem mit zwei Sensoren (S1, S2), die zum voneinander unabhängigen Erfassen von Elektronen, die von dem Werkstück während der Bearbeitung rückgestreut werden, und zum Ausgeben eines Ausgangssignals, das die Intensität der Rückstreuung wiedergibt, ausgebildet sind, und einer Auswerteschaltung (17 - 20), die die aus den Ausgangssignalen der beiden Sensoren (S1, S2) ein Differenzsignal und aus dem Differenzsignal ein Bild, das den Bearbeitungs- und Abtastbereich derart, dass das Differenzsignal in einer ersten Farbe und das negierte Differenzsignal in einer zweiten Farbe gleichzeitig dargestellt werden können, abbildet, erzeugt.

Bei dieser Bilderzeugungsvorrichtung weist vorzugsweise die Auswerteschaltung einen ersten Vorverstärker (17) mit einem Eingang, der mit einem der Sensoren (S1) verbunden ist, einen zweiten Vorverstärker (17) mit einem Eingang, der mit dem anderen Sensor (S2) verbunden ist, einen Differenzverstärker (18), dessen Eingänge mit den Ausgängen der beiden Vorverstärker (17, 17) verbunden sind, und einen Endverstärker (19) mit einem Eingang, der einen mit dem Ausgang des Differenzverstärkers (18) verbunden ist, und zwei Gegentorausgängen (19a, 19b), auf.

Vorzugsweise ist bei der Bilderzeugungsvorrichtung die Auswerteschaltung zum Wechseln der Farben mit denen das Differenzsignal und das negierte Differenzsignal gleichzeitig dargestellt werden, angepasst.

**Patentansprüche**

1. Verstärker zur schnellen Ansteuerung einer Induktivität, insbesondere einer Ablenkspule einer Elektronenstrahlkanone, mit einer Stromaddieranordnung zur Ansteuerung der Induktivität mit einem Ausgangsstrom der Stromaddieranordnung, die

 einen ersten Spannungsknoten ($U_1$), der dazu angepasst ist, auf einem ersten Potential zu liegen, einen zweiten Spannungsknoten ($U_v$), der dazu angepasst ist, mit einem Ausgang (AL) zur Stromversorgung der Induktivität (L) verbunden zu werden, und eine Mehrzahl von ersten, separat und unabhängig voneinander schaltbaren Brücken ($B1_1$, $B1_2$, $B1_3$, ..., $B1_k$), die jeweils einen in Reihe zwischen den ersten Spannungsknoten ($U_1$) und den zweiten Spannungsknoten ($U_v$) schaltbaren Widerstand ($R1_1$, $R1_2$, $R1_3$, ..., $R1_k$) mit einem Widerstandswert aufweisen,

 aufweist, wobei die Widerstandswerte so gewählt sind, dass ein erster Widerstand ($R1_1$) einen ersten Widerstandswert $WR1_1 = R_{min}$ aufweist, ein zweiter Widerstand ($R1_2$) einen zweiten Widerstandswert $WR1_2 \geq WR1_1$ aufweist, und der n-te Widerstand einen n-ten Widerstandswert $WR1_n \geq WR1_{n-1}$ aufweist.

2. Verstärker nach Anspruch 1, bei dem die Widerstandswerte so gewählt sind, dass der zweite Widerstand ($R1_2$) einen zweiten Widerstandswert $WR1_2 = m_2 R_{min}$ aufweist und der n-te Widerstand ($R1_n$) einen n-ten Widerstandswert $WR1_n = m_n WR1_{n-1}$ aufweist.

3. Verstärker nach Anspruch 1, bei dem die Stromaddieranordnung

 einen dritten Spannungsknoten ($U_2$), der dazu angepasst ist, auf einem zweiten Potential zu liegen, und eine Mehrzahl von zweiten, separat und unabhängig voneinander schaltbaren Brücken ($B2_1$, $B2_2$, $B2_3$, ..., $B2_k$), die jeweils einen in Reihe zwischen den dritten Spannungsknoten ($U_2$) und den zweiten Spannungsknoten ($U_v$) schaltbaren Widerstand ($R2_1$, $R2_2$, $R2_3$, ..., $R2_k$) mit einem Widerstandswert

aufweisen,
aufweist,
wobei die Widerstandswerte so gewählt sind, dass ein erster Widerstand ($R2_1$) einen ersten Widerstandswert $WR2_1 = R_{min}$ aufweist, ein zweiter Widerstand ($R2_2$) einen zweiten Widerstandswert $WR2_2 \geq WR2_1$ aufweist, und der n-te Widerstand einen n-ten Widerstandswert $WR2_n \geq WR2_{n-1}$ aufweist.

4. Verstärker nach Anspruch 3, bei dem die Widerstandswerte so gewählt sind, dass der zweite Widerstand ($Ri_2$) einen zweiten Widerstandswert $WRi_2 = m_2 R_{min}$, $2 \geq m_2 \geq 1$, $i = 1, 2$, aufweist und der n-te Widerstand ($Ri_n$) einen n-ten Widerstandswert $WRi_n = m_n WRi_{n-1}$, $2 \geq m_n \geq 1$, aufweist.

5. Verstärker nach Anspruch 2 oder 4, bei dem gilt:

 $2 > m_n \geq 1$ für n = 2, ..., p und $2 \geq m_n > 1$ für n = p + 1, ..., k.

6. Verstärker nach Anspruch 5, bei dem gilt:

 $m_n = 2$ für n = p + 1, ..., k.

7. Verstärker nach Anspruch 3 oder 4, bei dem der erste Spannungsknoten ($U_1$) dazu angepasst ist, mit einem Ausgang einer ersten Polarität einer spannungsstabilisierten Stromversorgung verbunden zu werden, und

 der dritte Spannungsknoten ($U_2$) dazu angepasst ist, mit einem Ausgang einer zweiten Polarität der spannungsstabilisierten Stromversorgung verbunden zu werden.

8. Verstärker nach einem der Ansprüche 1 bis 7, der eine Steuerschaltung zur Ansteuerung der schaltbaren Brücken, die zur separaten und voneinander unabhängigen Ansteuerung jeder der schaltbaren Brücken ausgebildet ist,
aufweist.

9. Verstärker nach Anspruch 8, bei dem die Steuerschaltung

 einen Dateneingang (3) zum Empfang eines ersten Datenworts mit einer ersten Bitzahl, einen Codewandler (6), der mit dem Dateneingang verbindbar ist und dazu angepasst ist, nach einer vorgegebenen Umwandlungsregel ein Eingangsdatenwort mit der ersten Bitzahl in ein Ausgangsdatenwort mit einer zweiten Bitzahl zur Ansteuerung der schaltbaren Brükken umzuwandeln, einen A/D-Wandler (7), der mit dem Ausgang (AL) verbunden ist, und ein zweites Datenwort mit der ersten Bitzahl ausgibt, eine Vergleichsschaltung (8), die das erste und das zweite Datenwort vergleicht und ein Vergleichsergebnis ausgibt, und

einen Hilfsverstärker (9), dessen Ausgang mit dem Ausgang (AL) verbunden ist und der an seinem Eingang ein Eingangssignal, das dem Vergleichsergebnis entspricht, empfängt,
aufweist.

10. Verstärker nach Anspruch 8 oder 9, bei dem die Steuerschaltung dazu angepasst ist, eine in Dauer und Amplitude an einen Betrag einer Änderung des an den Ausgang (AL) auszugebenden Stroms angepasste Übersteuerung des Verstärkers auszuführen.

11. Verstärkeranordnung mit
einem ersten Verstärker nach einem der Ansprüche 8 bis 10, dessen Ausgang (AL) ein erster Spulenanschluss ist, und
einem zweiten Verstärker nach einem der Ansprüche 8 bis 10, dessen Ausgang (AL) ein zweiter Spulenanschluss ist,
wobei die Steuerschaltung zur Ansteuerung des ersten Verstärkers und des zweiten Verstärkers ausgebildet ist.

12. Elektronenstrahlanlage mit
einer Elektronenstrahlkanone (11, 12, 13) mit einer ersten Ablenkspule zur Ablenkung des Elektronenstrahls (e) in einer ersten Richtung (14) und einer zweiten Ablenkspule zur Ablenkung des Elektronenstrahls (e) in einer zweiten Richtung (15),
einer Verstärkeranordnung nach Anspruch 11, deren erster Spulenanschluss mit der ersten Ablenkspule verbunden ist und deren zweiter Spulenanschluss mit der zweiten Ablenkspule verbunden ist, und
einem Speicher zur Speicherung eines digitalen Bearbeitungs- und Abtastmusters, das einen Weg des Elektronenstrahls (e) in einem Bearbeitungs- und Abtastbereich auf einem mit der Elektronenstrahlkanone zu bearbeitenden Werkstück definiert,
bei der die Steuerschaltung (21) zur Ansteuerung der Ablenkspulen zur Ablenkung des Elektronenstrahls gemäß des Bearbeitungs- und Abtastmusters angepasst ist.

13. Elektronenstrahlanlage nach Anspruch 12, die ein Sensorsystem mit zwei Sensoren (S 1, S2), die zum voneinander unabhängigen Erfassen von Elektronen, die von einem Werkstück während einer Bearbeitung mit dem Elektronenstrahl (e) rückgestreut werden, und zum Ausgeben eines Ausgangssignals, das die Intensität der Rückstreuung wiedergibt, ausgebildet sind, und
eine Auswerteschaltung, die aus den Ausgangssignalen der beiden Sensoren ein Differenzsignal und aus dem Differenzsignal ein Bild, das den Bearbeitungs- und Abtastbereich derart, dass das Differenzsignal in einer ersten Farbe und das negierte Differenzsignal in einer zweiten Farbe gleichzeitig dargestellt werden können, abbildet, erzeugt,
aufweist.

14. Elektronenstrahlanlage nach Anspruch 13, bei der die Auswerteschaltung
einen ersten Vorverstärker (17) mit einem Eingang, der mit einem der Sensoren (S 1) verbunden ist,
einen zweiten Vorverstärker (17) mit einem Eingang, der mit dem anderen Sensor (S2) verbunden ist,
einen Differenzverstärker (18), dessen Eingänge mit den Ausgängen der beiden Vorverstärker (17, 17) verbunden sind, und
einen Endverstärker (19) mit einem Eingang, der mit dem Ausgang des Differenzverstärkers verbunden ist, und zwei Gegentorausgängen
aufweist
und/oder
die Auswerteschaltung zum Wechseln der Farben, mit denen das Differenzsignal und das negierte Differenzsignal gleichzeitig dargestellt werden, angepasst ist.

**Claims**

1. An amplifier for high-speed driving of an inductive element, in particular, a deflection coil of an electron beam gun, including a current-adding array for driving the inductive element with an output current of the current-adding array, comprising
a first voltage node ($U_1$) adapted to be at a first potential,
a second voltage node ($U_v$) adapted to be coupled to an output (AL) for supplying the inductive element (L) with current, and
a first plurality of separately and independently switchable bridges ($B1_1$, $B1_2$, $B1_3$, ..., $B1_k$), each including a switchable resistor ($R1_1$, $R1_2$, $R1_3$, ..., $R1_k$) having a resistance value and being switchable in series between the first voltage node ($U_1$) and the second voltage node ($U_v$), wherein the resistance values are defined such that a first resistor ($R1_1$) has a first resistance value $WR1_1 = R_{min}$, a second resistor ($R1_2$) has a second resistance value $WR1_2 \geq WR1_1$, and the n-th resistor has an n-th resistance value $WR1_n \geq WR1_{n-1}$.

2. An amplifier according to claim 1, wherein the resistance values are defined such that the second resistor ($R1_2$) has a second resistance value $WR1_2 = m_2 R_{min}$, and the n-th resistor ($R1_n$) has an n-th resistance value $WR1_n = m_n R_{n-1}$.

3. An amplifier according to claim 1, wherein the current-adding array comprises a third voltage node ($U_2$) adapted to be at a second potential, and a second plurality of separately and independently

switchable bridges ($B2_1$, $B2_2$, $B2_3$, ..., $B2_k$), each including a switchable resistor ($R2_1$, $R2_2$, $R2_3$, ..., $R2_k$) having a resistance value and being switchable in series between the third voltage node ($U_2$) and the second voltage node ($U_v$), wherein the resistance values are defined such that a first resistor ($R2_1$) has a first resistance value $WR2_1 = R_{min}$, a second resistor ($R2_2$) has a second resistance value $WR2_2 \geq WR2_1$, and the n-th resistor has an n-th resistance value $WR2_n \geq WR2_{n-1}$.

4. An amplifier according to claim 3, wherein the resistance values are defined such that the second resistor ($Ri_2$) has a second resistance value $WRi_2 = m_2 R_{min}$, $2 \geq m_2 \geq 1$, $i = 1, 2$, and the n-th resistor ($Ri_n$) has an n-th resistance value $WRi_n = m_n WRi_{n-1}$, $2 \geq m_n \geq 1$.

5. An amplifier according to claim 2 or 4, wherein:

$$2 > m_n \geq 1 \text{ for } n = 2, ..., p \text{ and } 2 \geq m_n > 1 \text{ for } n = p + 1,...,k.$$

6. An amplifier according to claim 5, wherein:

$$m_n = 2 \text{ for } n = p + 1, ..., k.$$

7. An amplifier according to claim 3 or 4, wherein the first voltage node ($U_1$) is adapted to be connected to a first polarity of a regulated power supply, and the third voltage node ($U_2$) is adapted to be connected to a second polarity of the regulated power supply.

8. An amplifier according to any one of claims 1 to 7, comprising a control circuit configured to separately and independently drive each of the switchable bridges.

9. An amplifier according to claim 8, wherein the control circuit includes a data input (3) arranged and constructed to receive a first data word having a first bit count, a code converter (6) connectable with the data input and being adapted to convert, according to a predetermined conversion rule, an input data word having the first bit count into an output data word having a second bit count for driving the switchable bridges, an A/D converter (7) connected with the output (AL) and adapted to output a second data word having the first bit count, a comparator circuit (8) arranged and constructed to compare the first and second data words and to output a comparison result, and an auxiliary amplifier (9) having an output connected with the output (AL) and an input to receive an input signal corresponding to the comparison result.

10. An amplifier according to claim 8 or 9, wherein the control circuit is adapted to over-drive the amplifier, which over-driving operation is adapted, in duration and amplitude, to an amount of a change of the current that is to-be-output at the output (AL).

11. An amplifier assembly comprising a first amplifier according to any one of claims 8 to 10, the output (AL) of which is a first coil connection, and a second amplifier according to any one of claims 8 to 10, the output (AL) of which is a second coil connection, wherein the control circuit is configured to drive the first amplifier and the second amplifier.

12. An electron beam system comprising an electron beam gun (11, 12, 13) including a first deflection coil arranged and constructed to deflect the electron beam (e) in a first direction (14) and a second deflection coil arranged and constructed to deflect the electron beam (e) in a second direction (15), an amplifier assembly according to claim 11, the first coil connection of which is connected to the first deflection coil and the second coil connection of which is connected to the second deflection coil, and a memory storing a digital processing- and scanning-pattern, which pattern defines a path of the electron beam (e) in a processing- and scanning-area on a work piece to be processed using the electron beam gun, wherein the control circuit (21) is adapted to drive the deflection coils so as to deflect the electron beam according to the processing- and scanning-pattern.

13. An electron beam system according to claim 12, comprising a sensor system including two sensors (S1, S2) arranged and constructed to independently detect electrons that are back-scattered during a processing with the electron beam (e), and to output an output signal representative of the intensity of the detected back-scattered electrons, and an evaluation circuit arranged and constructed to generate a differential signal from the output signals of the two sensors and to generate an image from the differential signal, the image containing information that depicts the processing- and scanning-area such that the differential signal can be displayed in a first color and the inverse differential signal can be simultaneously displayed in a second color.

14. An electron beam system according to claim 13, wherein the evaluation circuit includes a first pre-amplifier (17) having an input connected with one of the sensors (S1), a second pre-amplifier (17) having an input connected with the other sensors (S2),

a differential amplifier (18) having inputs respectively connected with the outputs of the first and second pre-amplifiers (17, 17), and

a power amplifier (19) having an input connected with the output of the differential amplifier and two push-pull outputs

and/or

the evaluation circuit is adapted to display the differential signal and the inverse differential signal in different colors.

## Revendications

1. Amplificateur destiné à l'excitation rapide d'une inductance, notamment d'une bobine de déviation d'un canon à faisceau d'électrons, comportant un dispositif sommateur de courant pour exciter l'inductance avec un courant de sortie du dispositif sommateur de courant, qui comprend

   un premier noeud de tension ($U_1$), qui est adapté pour être à un premier potentiel,

   un second noeud de tension ($U_v$), qui est adapté de sorte à être relié à une sortie (AL) pour l'alimentation en courant de l'inductance (L), et

   une pluralité de premiers ponts commutables séparément et indépendamment l'un de l'autre ($B1_1$, $B1_2$, $B1_3$,...., $B1_k$), qui comportent chacun en série entre le premier noeud de tension ($U_1$) et le second noeud de tension ($U_v$) une résistance commutable ($R1_1$, $R1_2$, $R1_3$,...., $R1_k$) ayant une valeur de résistance, les valeurs de résistance étant choisies de telle sorte qu'une première résistance ($R1_1$) présente une première valeur de résistance $WR1_1 = R_{min}$, qu'une seconde résistance ($R1_2$) présente une seconde valeur de résistance $WR1_2 \geq WR1_1$, et que la nième résistance présente une nième valeur de résistance $WR1_n \geq WR1_{n-1}$.

2. Amplificateur selon la revendication 1, dans lequel les valeurs de résistance sont choisies de telle sorte que la seconde résistance ($R1_2$) présente une seconde valeur de résistance $WR1_2 = m_2R_{min}$, et que la nième résistance ($R1_n$) présente une nième valeur de résistance $WR1_n = m_nWR1_{n-1}$.

3. Amplificateur selon la revendication 1, dans lequel le dispositif sommateur de courant comprend

   un troisième noeud de tension ($U_2$), qui est adapté pour être à un second potentiel, et

   une pluralité de seconds ponts commutables séparément et indépendamment l'un de l'autre ($B2_1$, $B2_2$, $B2_3$,...., $B2_k$), qui comportent chacun en série entre le troisième noeud de tension ($U_2$) et le second noeud de tension ($U_v$) une résistance commutable ($R2_1$, $R2_2$, $R2_3$,...., $R2_k$) ayant une valeur de résistance,

les valeurs de résistance étant choisies de telle sorte qu'une première résistance ($R2_1$) présente une première valeur de résistance $WR2_1 = R_{min}$, qu'une seconde résistance ($R2_2$) présente une seconde valeur de résistance $WR2_2 \geq WR2_1$, et que la nième résistance présente une nième valeur de résistance $WR2_n \geq WR2_{n-1}$.

4. Amplificateur selon la revendication 3, dans lequel les valeurs de résistance sont sélectionnées de telle sorte que la seconde résistance ($Ri_2$) présente une seconde valeur de résistance $WRi_2 = m_2R_{min}$, telle que $2 \geq m_2 \geq 1$, i = 1, 2 et que la nième résistance ($Ri_n$) présente une nième valeur de résistance $WRi_n = m_nWRi_{n-1}$, $2 \geq m_n \geq 1$.

5. Amplificateur selon la revendication 2 ou 4, dans lequel $2 \geq m_n \geq 1$ pour n = 2, ..., p et $2 \geq m_n > 1$ pour n = p + 1,..., k.

6. Amplificateur selon la revendication 5, dans lequel $m_n=2$ pour n = p + 1,..., k.

7. Amplificateur selon la revendication 3 ou 4, dans lequel le premier noeud de tension ($U_1$) est adapté de sorte à être relié à une sortie d'une première polarité d'une alimentation en courant stabilisée en tension, et le troisième noeud de tension ($U_2$) est adapté de sorte à être relié à une sortie d'une seconde polarité de l'alimentation en courant stabilisée en tension.

8. Amplificateur selon l'une quelconque des revendications 1 à 7, qui comprend un circuit de commande destiné à exciter les ponts commutables, qui est formé de façon à permettre une excitation séparée et indépendante de chacun des ponts commutables.

9. Amplificateur selon la revendication 8, dans lequel le circuit de commande comprend

   une entrée de données (3) destinée à recevoir un premier mot de données ayant un premier nombre de bits,

   un convertisseur de code (6), qui peut être relié à l'entrée de données et est adapté de sorte à convertir, selon une règle de conversion prescrite, un mot de données d'entrée ayant le premier nombre de bits en un mot de données d'entrée ayant un second nombre de bits pour exciter les ponts commutables, un convertisseur A/N (7), qui est relié à la sortie (AL) et qui extrait un second mot de données ayant le premier nombre de bits,

   un circuit comparateur (8), qui compare le premier et le second mot de données et délivre un résultat de comparaison, et

   un amplificateur auxiliaire (9), dont la sortie est reliée à la sortie (AL) et qui reçoit à son entrée un signal d'entrée, qui correspond au résultat de la comparaison.

**10.** Amplificateur selon la revendication 8 ou 9, dans lequel le circuit de commande est adapté de sorte à exécuter une commande prioritaire de l'amplificateur adaptée en durée et en amplitude à une quantité d'une modification du courant à délivrer à la sortie (AL).

**11.** Ensemble amplificateur comprenant
un premier amplificateur selon l'une quelconque des revendications 8 à 10, dont la sortie (AL) constitue une première connexion à la bobine, et
un second amplificateur selon l'une quelconque des revendications 8 à 10, dont la sortie (AL) constitue une seconde connexion à la bobine,
dans lequel le circuit de commande est formé de sorte à exciter le premier amplificateur et le second amplificateur.

**12.** Installation de bombardement d'électrons comprenant un canon à faisceau d'électrons (11, 12, 13) comportant une première bobine de déviation destinée à dévier le faisceau d'électrons (e) dans une première direction (14) et une seconde bobine de déviation destinée à dévier le faisceau d'électrons (e) dans une seconde direction (15),
un ensemble amplificateur selon la revendication 11, dont la première connexion de bobine est reliée à la première bobine de déviation et dont la seconde connexion de bobine est reliée à la seconde bobine de déviation, et une mémoire pour enregistrer un motif d'usinage et d'échantillonnage, qui définit une trajectoire du faisceau d'électrons (e) dans une zone d'usinage et d'échantillonnage sur une pièce à usiner avec le canon à faisceau d'électrons, dans laquelle le circuit de commande (21) est adapté de sorte à exciter les bobines de déviation pour dévier le faisceau d'électrons selon le motif d'usinage et d'échantillonnage.

**13.** Installation de bombardement d'électrons selon la revendication 12, qui comprend :

un système de détection comportant deux capteurs (S1, S2) destinés à détecter indépendamment l'un de l'autre les électrons rétrodiffusés par une pièce à usiner au cours de l'usinage par faisceau d'électrons (e) et conçus de façon à émettre un signal de sortie, qui restitue l'intensité de la rétrodiffusion, et
un circuit d'analyse, qui produit un signal différentiel à partir des signaux de sortie des deux capteurs et, à partir du signal différentiel, une image qui reproduit la zone d'usinage et d'échantillonnage de telle sorte que le signal différentiel et le signal différentiel inversé peuvent être représentés simultanément et respectivement dans une première couleur et une seconde couleur.

**14.** Installation de bombardement d'électrons selon la revendication 13, dans laquelle le circuit d'analyse comprend
un premier préamplificateur (17) comportant une entrée, qui est reliée à l'un des détecteurs (S1),
un second préamplificateur (17) comportant une entrée, qui est reliée à l'autre détecteur (S2),
un amplificateur différentiel (18), dont les entrées sont reliées aux sorties des deux préamplificateurs (17, 17), et
un amplificateur terminal (19) comportant une entrée, qui est reliée à la sortie de l'amplificateur différentiel, et deux sorties en push pull
et/ou
le circuit d'analyse est adapté de sorte à changer les couleurs avec lesquelles le signal différentiel et le signal différentiel inversé peuvent être représentés simultanément.

Fig. 1

# Fig. 2

EP 1 885 059 B1

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 1053091
- DE 2149106
- US 4891523 A
- US 3431457 A
- US 3390222 A